# EUROPEAN PATENT APPLICATION

(11) **EP 3 852 141 A1**
(43) Date of publication of application: **21.07.2021**
(21) Application number: 20166590.8
(22) Date of filing: 30.03.2020
(51) Int. Cl.: H01L 25/075, H01L 33/54

(54) **MICRO LED LIGHT EMITTING DEVICE AND MANUFACTURING METHOD THEREOF**

(30) Priority: 15.01.2020 TW 109101403
(71) Applicant: Unity Opto Technology Co., Ltd., New Taipei City (TW)
(72) Inventor: CHEN, Chun-Hung, New Taipei City (TW); PENG, Tzu-Chieh, NEW TAIPEI CITY (TW); LU, Ko-Wei, NEW TAIPEI CITY (TW)
(74) Representative: Cabinet Chaillot

(57) **Abstract**

The micro LED light emitting device includes at least one light emitting element and a barrier layer. The light emitting element is provided with a plurality of micro LEDs arranged in a matrix of 2^{∗}2 or more, the adjacent micro LEDs have a distance from each other to form a trellis ditch, and the height of these micro LEDs is H. The barrier layer has an upper portion and a lower portion, the light transmittance of the upper portion is 85% or more, and the light transmittance of lower portion is 30% or less; the height of the lower portion after filling the trellis ditches is L; and 0.7H ≦ L ≦ 1.2H; the upper portion is covered above the lower portion, so that there is no gap between the barrier layer and the micro LEDs.

## Description

### TECHNICAL FILED OF THE INVENTION

The present disclosure generally relates to the field of micro LEDs. More particularly, the present disclosure relates to a micro LED light emitting device and its manufacturing method capable of installing a barrier layer between the micro LEDs quickly to prevent possible interferences between the micro LEDs effectively and providing an excellent overall installation stability of the packaged micro LEDs.

### DESCRIPTION OF THE PRIOR ART

Technically, micro LED display devices are currently in a state of vigorous development. Compared with the conventional display devices, the micro LED display devices can provide higher contrast and performance and better visual function. The so-called micro LED display device technology generally refers to the technology of LED display devices having a size smaller than a micron (wherein the conventional LED display device has a size of several millimetres), and then the three-color (RGB) micro LEDs grown on an epitaxial substrate by a mass transfer technology are transferred to a display substrate. After the micro LED with the RGB pixels is addressed, the brightness of the micro LED is controlled to achieve a full-color display performance. With the consideration of the lattice matching of materials and size difference of substrates, it is necessary to transfer millions to tens of millions of micro LEDs to the display substrate after the epitaxial process. Since the transfer process must be completed within a reasonable time period, there is still no well-developed technology for transferring a large quantity of micro LEDs under the requirements for a quantity of a single transfer and a high precision. Therefore, it is one of the main subjects for related manufacturers to transfer a large quantity of micro LEDs effectively.

In the conventional direct or edge LED display devices, various grain arrangements of RGB or RGGB in each pixel and the interval between pixels have to avoid the interference between color lights emitted from different crystal grains or pixels. Similarly, the micro LEDs come with different sizes and have a high density, so that different color lights have a serious interference with each other, and such interference must be eliminated. Since the LED size is relatively larger and the interval between pixels is also larger, therefore a barrier layer can be formed by a dispensing method after the layout is completed. According to this arrangement, the interference between different color lights or adjacent pixels can be blocked. The dispensing method can be used for large-sized LEDs effectively, but the micro LEDs have a very small interval of RGB and a very small distance between adjacent pixels, and this method cannot be used to set up the barrier layer effectively and precisely in micro LEDs.

On the other hand, groove-like structures are often formed directly on an epitaxy substrate and provided for picking and transfer the RGB LEDs in a massive transfer technology. With reference to FIG. 1 for a stable cavity and a stable structure disclosed in US2015/0008389A1, micro LEDs 105 are transferred directly to a stable cavity sidewall 147 and an open space 177, wherein the function of the stable cavity is to limit the position of each micro LED 105, so that even if a stable structure 152 of any one micro LED 105 loses its adhesiveness, the micro LED 105 will be maintained in the stable cavity formed by the stable cavity sidewall 147 to prevent affecting the effect of picking adjacent components. However, the partition structure is installed onto the epitaxy substrate instead of the display substrate. As a result, even if the same concept is applied to the display substrate, the partition structure will still have a very large gap between the sidewall 147 and the open space 177 and the micro LED and thus resulting in a poor light blocking effect. Further, if the display substrate is installed directly onto the pre-set partition structures and aligned after the picking, and the size of the groove-like structure of the micro LED is designed substantially the same as that of the micro LED, the light blocking effect can be improved, but the alignment will become difficult and thus causing a failure of transfer. On the other hand, a groove formed on the display substrate for transferring and disposing the micro LED should be designed with a relatively larger opening to facilitate the transfer process and improve the transfer rate. However, such arrangement has the drawback of failing to achieve the light blocking effect effectively. Further, if the micro LED simply uses the groove to form the barrier layer after the packaging, the stability of the packaged micro LED will have a poor performance.

Further, the massive transfer method usually have the issues on the precision and moving speed of the mechanical tools during the picking and transferring process and thus cannot meet the speed requirement of setting millions of micro components per minute. To break through the aforementioned bottleneck, a fluid assembling technology is introduced. For example, U.S. Pat. Publication No. US2017/0133558A1 discloses a fluid assembling structure of a micro LED as shown in FIG.2m a liquid suspension 300 flows in a direction as indicated by an arrow in the figure to facilitate the micro LED 302 to fall in to a hole 204 of a substrate 200, wherein the hole 204 and the substrate 200 are pre-formed, but such structure still cannot take care of the transfer convenience and the light blocking effect concurrently. In other words, if the opening is too large, the transfer will be convenient, but the light blocking effect will be poor; and if the opening is too small, the light blocking effect will be high, but the transfer will be failed. As to the stability of the packaged micro LED, this method also has the same drawbacks as the previous method.

In view of the aforementioned drawbacks of the prior art, the team of this disclosure based on years of experience in the related industry to conduct extensive research and experiment, and finally developed a micro LED light emitting device and its manufacturing method, wherein the manufacturing method is capable of creating a barrier layer quickly and effectively and manufacturing a micro LED light emitting device with an excellent structural stability. Since there is on gap between the barrier layer and the micro LEDs in the matrix of micro LEDs, therefore the RGB grains in a same pixel and the light emitting elements between adjacent pixels will not interfere with each other. Even if the light emitting elements are spliced to form a micro LED display device, this manufacturing method can effectively cover the splicing line of light emitting elements to improve the aesthetic appearance of the display device.

### SUMMARY OF THE INVENTION

To achieve the aforementioned and other objectives, the present disclosure provides a manufacturing method capable of forming a barrier layer between the micro LEDs quickly and a light emitting device manufactured by the method, wherein the barrier layer is filled completely between the micro LEDs, and there is no gap between the barrier layer and the micro LED, so that the manufactured display device comprised of the light emitting elements has an excellent display function and an aesthetic look.

To achieve the aforementioned and other objectives, this disclosure also provides a micro LED light emitting device, comprising: at least one light emitting element, having a plurality of micro LEDs installed thereon and arranged into a matrix of 2*2 or more, wherein the adjacent micro LEDs have an interval therebetween to form a trellis ditch, and the micro LEDs have a height H; and a barrier layer, having an upper portion and a lower portion, wherein the upper portion has a light transmittance greater than or equal to 85%, the lower portion has a light transmittance smaller than or equal to 30%; the lower portion filled into the trellis ditch has a height L, and 0.7H≦L≦1.2H, and the upper portion is covered onto the lower portion, and no gap exists between the barrier layer and the micro LEDs, so as to improve the light blocking effect effectively, and the packaged micro LED light emitting device has an excellent overall stability, and the micro LED or the barrier layer will not fall off easily.

When the light emitting element comes with a plural quantity, the trellis ditch comprises adjacent areas with the light emitting elements arranged next to each other. Therefore, when it is necessary to expand the display range by splicing a plurality of light emitting elements, this technical measure can be used to cover the splicing line included in the adjacent areas and improve the aesthetic appearance of the display device.

When the light emitting element comes with a single or plural quantity, and the barrier layer is a deformable material after being pressed, and the barrier layer is formed by using an opaque material doping into a transparent material and allowed precipitating to form the lower portion and the upper portion with different light transmittances. When the barrier layer is formed by attaching two or more homogeneous or heterogeneous composites, their adhesiveness and flow stagnation may vary and cause the laminated barrier layer to flow into the trellis ditch due to the poor adhesion or even the separation of the composites. Therefore this technical measure can be used to avoid the aforementioned problems.

Preferably, when the light emitting element comes with a single or plural quantity, the aforementioned opaque material has an optical property of light absorption or light reflection which can improve the light blocking effect.

In an embodiment, when the light emitting element comes with a single or plural quantity, the transparent material is PMMA. The micro LEDs have a height smaller than or equal to 130µm. In the condition of such small size, this disclosure still can set the barrier layer between the micro LEDs effectively.

Preferably, when the light emitting element comes with a single or plural quantity the lower portion and the upper portion of the barrier layer are set by a spraying method sequentially. Alternatively, the lower portion of the barrier layer is formed by using a spraying method and then covered onto the lower portion and fixed by using a pressing method. Regardless of adopting which fixing and setting method, the barrier layer can be formed quickly to improve the structural stability and light blocking effect of the packaged micro LED light emitting devices.

To manufacture the aforementioned micro LED light emitting device, this disclosure provides a micro LED light emitting device manufacturing method used for performing a manufacturing process in a vacuum cavity, comprising the steps of:
providing at least one light emitting element, wherein the light emitting element has a plurality of micro LEDs arranged into a matrix of 2*2 or more, and the light emitting elements are installed onto a base inside the cavity, and the adjacent micro LEDs has a gap therebetween to form a trellis ditch; setting a barrier layer onto the micro LEDs, wherein the barrier layer has an upper portion and a lower portion, and the upper portion has a light transmittance greater than or equal to 85%, and the lower portion has a light transmittance smaller than or equal to 30%; and applying a pressure directly or indirectly to the barrier layer by a hot-pressed part to produce deformation, so as to move and flow the lower portion of the barrier layer into the trellis ditch, and the lower portion after being filled into the trellis ditch has a height L, and 0.7H≦L≦1.2H, and the upper portion is covered onto the lower portion, so that there is no gap between the barrier layer and the micro LEDs. Therefore, the barrier layer can be set quickly, and the product manufactured by the manufacturing method has an excellent structural stability and the micro LED or the barrier layer will not fall off easily.

Preferably, when the light emitting element comes with a plural quantity, the trellis ditch comprises adjacent areas with the light emitting elements arranged next to each other. Therefore, when it is necessary to expand the display range by splicing a plurality of light emitting elements, this technical measure can be used to cover the splicing line included in the adjacent areas and improve the aesthetic appearance of the display device.

Preferably, when the light emitting element comes with a single or plural quantity, the barrier layer is formed by using an opaque material doping into a transparent material and allowed precipitating to form the lower portion and the upper portion with different light transmittances. When the barrier layer is formed by attaching two or more homogeneous or heterogeneous composites, their adhesiveness and flow stagnation may vary and cause the laminated barrier layer to flow into the trellis ditch due to the poor adhesion or even the separation of the composites. Therefore this technical measure can be used to avoid the aforementioned problems.

Preferably, when the light emitting element comes with a single or plural quantity, the aforementioned opaque material has an optical property of light absorption or light reflection to improve the light blocking effect.

Preferably, when the light emitting element comes with a single or plural quantity, the hot-pressed part and the barrier layer has a buffer layer disposed therebetween, and the hot-pressed part applies a pressure to the barrier layer indirectly through the buffer layer, or the barrier layer is attached and fixed to a carrier plate, and when the hot-pressed part applies the pressure, the carrier plate receives the pressure first, and then the barrier layer produces deformation indirectly, so as to improve the flowing effect of the laminated barrier layer and prevent the barrier layer from being damaged after the lamination.

Preferably, when the light emitting element comes with a single or plural quantity, the process temperature in the cavity is greater than or equal to 60 degrees Centigrade, and the hot-pressed part has a press strength greater than or equal to 500 newtons.

To manufacture the aforementioned micro LED light emitting device, this disclosure discloses another micro LED light emitting device manufacturing method, comprising the steps of: providing at least one light emitting element, wherein the light emitting element has a plurality of micro LEDs arranged into a matrix of 2*2 or more, and the light emitting elements are installed onto a base inside the cavity, and the adjacent micro LEDs has a gap therebetween to form a trellis ditch; and setting a barrier layer into the trellis ditch, wherein the barrier layer has an upper portion and a lower portion, and after the lower portion is formed by a spraying method, the upper portion is formed at the top of the lower portion by the spraying method; wherein the upper portion has a light transmittance greater than or equal to 85%, and the lower portion has a light transmittance smaller than or equal to 30%, and the lower portion after being filled into the trellis ditch has a height L, and 0.7H≦L≦1.2H, and the upper portion is covered onto the lower portion, so that there is no gap between the barrier layer and the micro LEDs.

When the light emitting element comes with a plural quantity, the trellis ditch comprises adjacent areas with the light emitting elements arranged next to each other.

To manufacture the aforementioned micro LED light emitting device, this disclosure further discloses a further micro LED light emitting device manufacturing method, a micro LED light emitting device manufacturing method, comprising the steps of: providing at least one light emitting element, wherein the light emitting element has a plurality of micro LEDs arranged into a matrix of 2*2 or more, and the light emitting elements are installed onto a base inside the cavity, and the adjacent micro LEDs has a gap therebetween to form a trellis ditch; and
setting a barrier layer into the trellis ditch, wherein the barrier layer has an upper portion and a lower portion, and after the lower portion is formed by a spraying method, the upper portion is covered onto the lower portion and fixed by a pressing method; wherein the upper portion has a light transmittance greater than or equal to 85%, and the lower portion has a light transmittance smaller than or equal to 30%, and the lower portion after being filled into the trellis ditch has a height L, and 0.7H≦L≦1.2H, and the upper portion is covered onto the lower portion, so that there is no gap between the barrier layer and the micro LEDs. When the light emitting element comes with a plural quantity, the trellis ditch comprises adjacent areas with the light emitting elements arranged next to each other.

In summation of the description the aforementioned micro LED light emitting device and its manufacturing method, there is no gap between the barrier layer and the micro LEDs, so that the overall stability is very high. In addition, the barrier layer is comprised of two structures with two different light transmittances to achieve the effects of avoiding mutual interferences between the lights of adjacent micro LEDs or pixels effectively and improving the light emission efficiency. Unlike the conventional dispensers having the drawbacks of taking much time and having difficulty to form the barrier layer between the micro LEDs, the manufacturing method of this disclosure has a high efficiency. For the micro LEDs with a very small size, the method of this disclosure can set the barrier layer between the micro LEDs accurately. When it is necessary to expand the display range by splicing a plurality of light emitting elements, this technical measure of this disclosure can be used to cover the splicing line included in the adjacent areas and improve the aesthetic appearance of the display device.

### BRIEF DESCRIPTION OF THE DRAWINGS

The accompanying drawings are included to provide a further understanding of the disclosure, and are incorporated in and constitute a part of this specification. The drawings illustrate embodiments of the disclosure and, together with the description, serve to explain the principles of the disclosure.

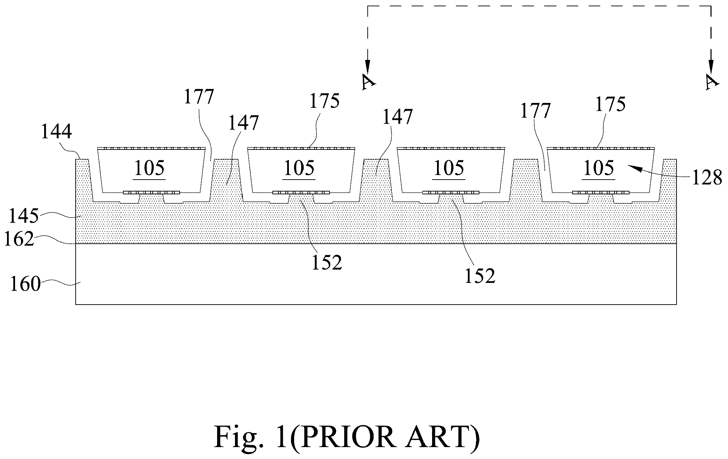

FIG. 1 is a schematic view of a stable cavity and a stable structure for a massive transfer of micro LEDs in accordance with a prior art;

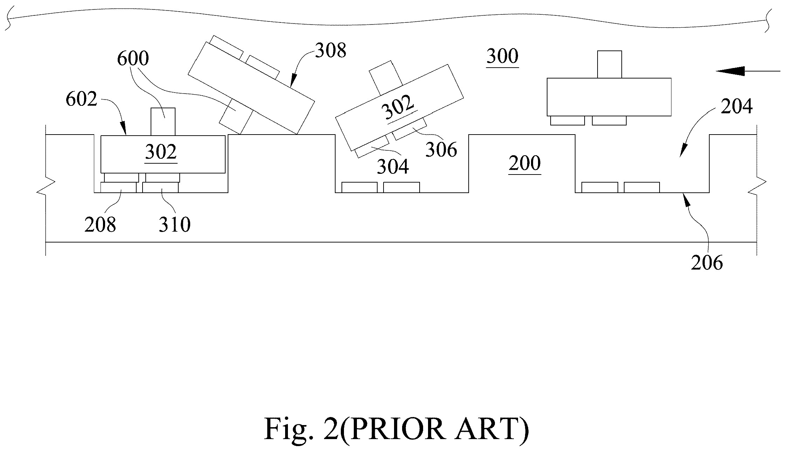

FIG. 2 is a schematic view of a conventional micro LED using a fluid architecture for a massive transfer of the micro LED;
FIG. 3 is a schematic view of a micro LED light emitting device of this disclosure;
FIG. 4A is a first schematic view of laminating a material of a barrier layer without a layered characteristic in accordance with a preferred embodiment of this disclosure;
FIG. 4B is a second schematic view of laminating a material of a barrier layer without a layered characteristic in accordance with an embodiment of this disclosure;
FIG. 5A is a first schematic view of laminating a material of a barrier layer with a layered characteristic in accordance with an embodiment of this disclosure;
FIG. 5B is a second schematic view of laminating a material of a barrier layer with a layered characteristic in accordance with a preferred embodiment of this disclosure;
FIG. 6 is a flow chart of a micro LED light emitting device manufacturing method in accordance with a preferred embodiment of this disclosure;
FIG. 7A is a top view of a micro LED light emitting device of this disclosure;
FIG. 7B is a schematic view of a micro LED light emitting device manufacturing method in accordance with a preferred embodiment of this disclosure;
FIG. 8A is a schematic view of a barrier layer filled into a trellis ditch with a relatively larger size in accordance with a preferred embodiment of this disclosure;
FIG. 8B is a schematic view of a barrier layer filled into a trellis ditch with a relatively smaller size in accordance with a preferred embodiment of this disclosure;
FIG. 9A is a first schematic view of a barrier layer laminated and then filled into a trellis ditch in accordance with a preferred embodiment of this disclosure;
FIG. 9B is a second schematic view of a barrier layer laminated and then filled into a trellis ditch in accordance with a preferred embodiment of this disclosure;
FIG. 10 is a flow chart of another micro LED light emitting device manufacturing method in accordance with a preferred embodiment of this disclosure;
FIG. 11 is a flow chart of a further micro LED light emitting device manufacturing method in accordance with a preferred embodiment of this disclosure;
FIG. 12A is a schematic view of a plurality of light emitting elements spliced with each other and having no barrier layer in accordance with this disclosure; and
FIG. 12B is a schematic view of a plurality of light emitting elements spliced with each other and installed with a barrier layer in accordance with this disclosure.

### DESCRIPTION OF THE EMBODIMENTS

Reference will now be made in detail to the present embodiments of the disclosure, examples of which are illustrated in the accompanying drawings. Wherever possible, the same reference numbers are used in the drawings and the description to refer to the same or like parts.

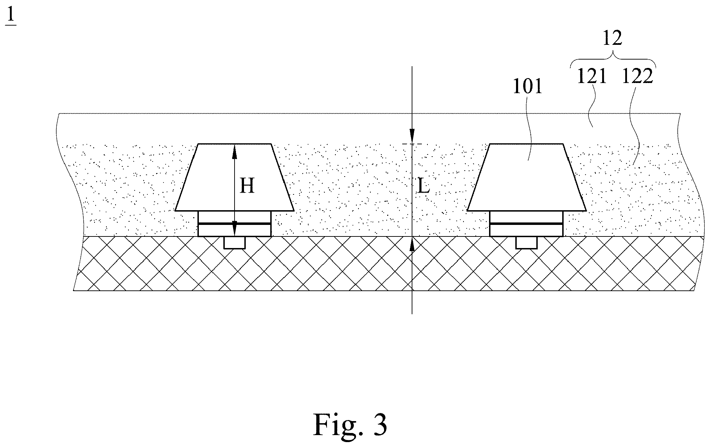

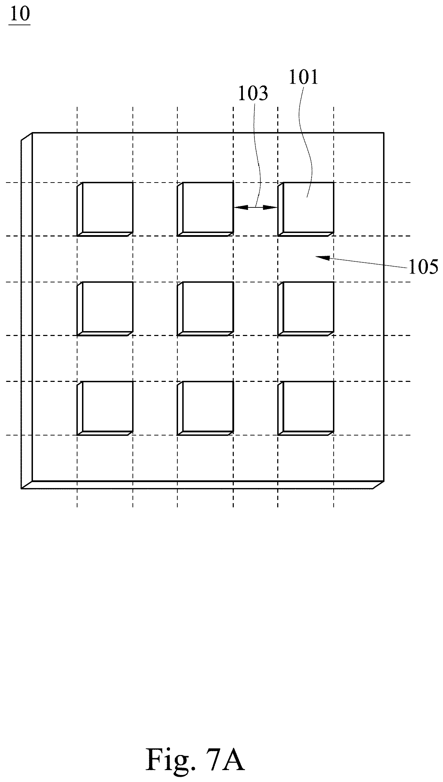

With reference to FIGS. 3 and 7A for a schematic view and a top view of the structure of a micro LED light emitting device of this disclosure respectively, the micro LED light emitting device 1 comprises: at least one light emitting element 10 and a barrier layer 12. The light emitting element 10 has a plurality of micro LEDs 101 arranged into a matrix of 2*2 or more, wherein the adjacent micro LEDs 101 have a gap 103 therebetween to form a trellis ditch 105, and the micro LEDs 101 have a height H. The micro LEDs 101 can be used to form a display device. Regardless of adjacent micro LEDs 101 or adjacent pixel units, their lighting ranges may be overlapped to affect the light emission performance. To reduce or eliminate this situation, this disclosure further sets the barrier layer 12 into the trellis ditch 105, so that the mutual interference of the lights emitted by adjacent micro LEDs 101 can be blocked. In general, an opaque material is designed between the micro LEDs 101 to block the interference between the lights of the micro LEDs 101, but such arrangement has the drawback of unable to fix the barrier layer 12 with the micro LEDs 101 closely, so that the packaged light emitting elements 10 have a lower stability and the barrier layer 12 or the micro LEDs 101 may even fall off easily. Further, the use of the dispensing method may cause the barrier layer 12 to be set too high with respect to the micro LEDs 101; or the light exiting surface of the micro LEDs 101 to be too thick that affects the lighting performance. To prevent the aforementioned drawbacks, the design of the barrier layer 12 of this disclosure includes an upper portion 121 and a lower portion 122, wherein the upper portion 121 has a light transmittance greater than or equal to 85%, and the lower portion 122 has a light transmittance smaller than or equal to 30%; and the lower portion 122 after being filled into the trellis ditch 105 has a height L, and 0.7H≦L≦1.2H, and the upper portion 121 is covered onto the lower portion 122, and there is no gap between the barrier layer 12 and the micro LEDs 101. Therefore, the lower portion 122 with a lower light transmittance is used to achieve the effect of blocking the mutual interference between the lights, and the upper portion 121 with a higher light transmittance is capable of securing the setting of the lower portion 122 and improving the structural stability of the packaged micro LEDs 101. It is noteworthy that the so-called "packaging process" here generally includes the subsequent process of setting and fixing the barrier layer 12, but it is not just limited to a certain process such as a semiconductor manufacturing process, or an IC chip or LED manufacturing process only. Further, experiment results show that an LED light source is directional, but Lambertian emission pattern indicates that the distribution of light intensity decreases with the cosine of an included angle between the direction of the incident light and the surface normal. For example, the largest intensity is situated above the surface perpendicular to the LED, and if the included angle is equal to 60 degrees, then the intensity is decreased to half of the largest intensity. With such property, it is not necessary to block the light with too much attenuation intentionally in order to avoid lowering the overall lighting performance. In fact, it is intentionally to absorb the light emitted from a side of the micro LEDs 101, the measurement will influence the overall light intensity and lower the brightness of the display device. The structure of this disclosure integrates the functions of blocking the light effectively and using the side light for enhance the lighting effect without blocking the vertical position of the micro LEDs 101 having the largest light intensity. In summation, the barrier layer 12 of this disclosure uses a structure with two layers of different light transmittances and without any gap between the barrier layer 12 and the micro LEDs 101 to enhance the stability of the packaged micro LEDs 101 without affecting the light performance. In the meantime, the lower portion 122 is configured with a specific height relative to the micro LEDs 101 to meet the requirement of 0.7H≦L ≦1.2H, so as to achieve the effects of blocking the mutual interference of adjacent side lights and enhancing the overall light intensity.

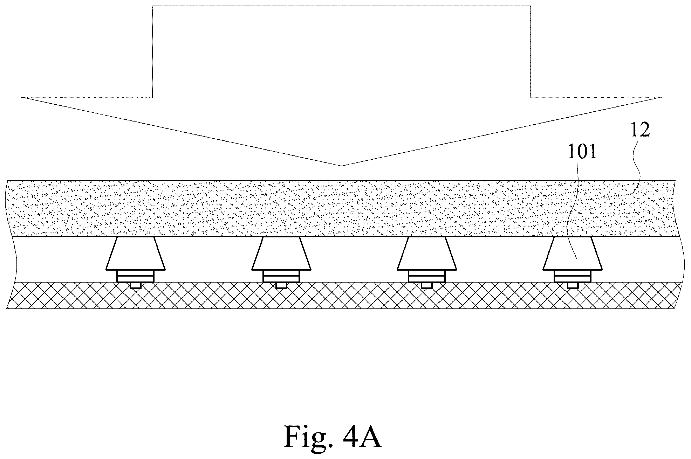

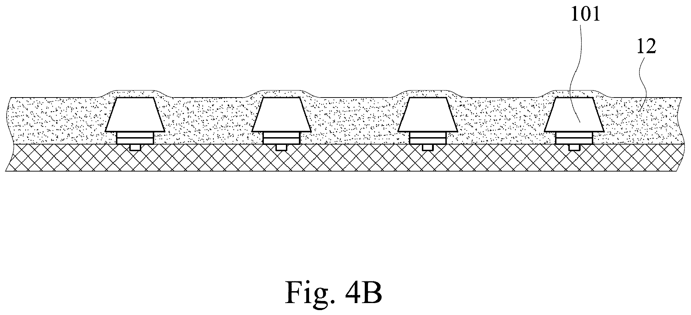

To set the barrier layer 12 between the micro LEDs 101 effectively, this disclosure adopts a deformable material after being compressed for the barrier layer 12. In other words, such material of the barrier layer 12 is covered onto the already transferred or set micro LED 101, and a hot-press process is carried out in the cavity, so that the material of the barrier layer 12 is compressed and filled between the micro LEDs 101. With reference to FIGS. 4A and 4B for the first and second schematic views of laminating a material of a barrier layer 12 without a layered characteristic in accordance with a preferred embodiment of this disclosure respectively, it is noteworthy that the embodiment of this disclosure is not intended for limiting the scope of this disclosure. This embodiment is provided for illustrating the basic process model during an experiment conducted by the discloser of this disclosure, so that any modification or adjustment of parameters, materials or conditions can be adopted to improve the overall performance. In the embodiments as shown in FIGS. 4A and 4B, the material of the barrier layer 12 at least has a physical property capable of separating lights. In other words, the lamination process can effectively and quickly set the barrier layer 12 between the micro LEDs 101.

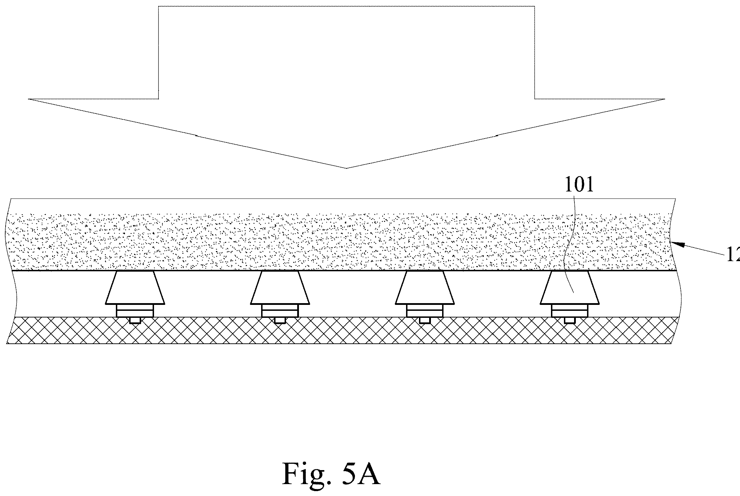

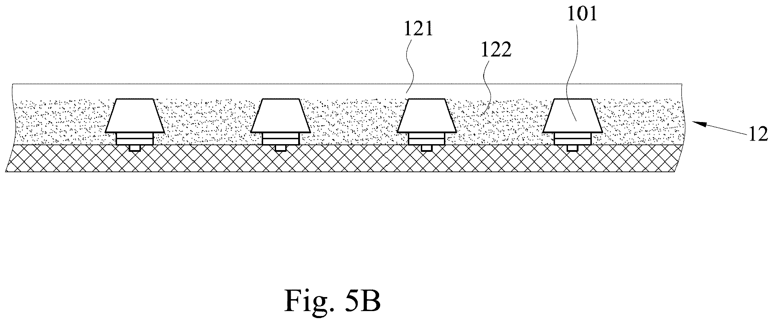

To enhance the stability of the micro LEDs 101, this disclosure bases on this embodiment and further adjusts the conditions of the manufacturing process to manufacture the structure as shown in FIGS. 5A and 5B, wherein FIGS. 5A and 5B are the first and second schematic views of laminating a material of a barrier layer 12 with a layered characteristic respectively. In this embodiment, the barrier layer 12 is divided into an upper layer and a lower layer, and these two layers are made of materials of different light transmittances, and then pressed, so that the lower portion 122 is filled between the micro LEDs 101, and the upper portion 121 is covered onto the lower portion 122 or the micro LEDs 101. As a result, the mutual interference between adjacent micro LEDs 101 can be blocked effectively and the light performance will not be influenced. In the meantime, this arrangement has both protection and stabilization of the packaged structure.

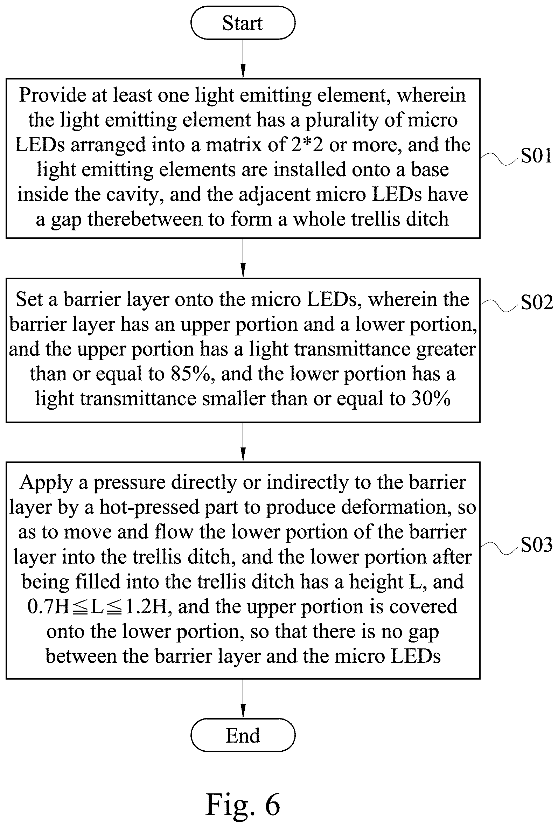

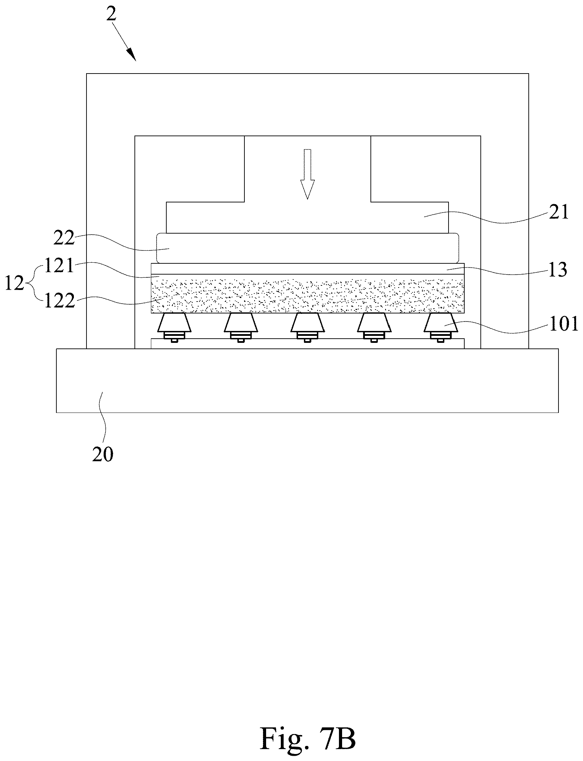

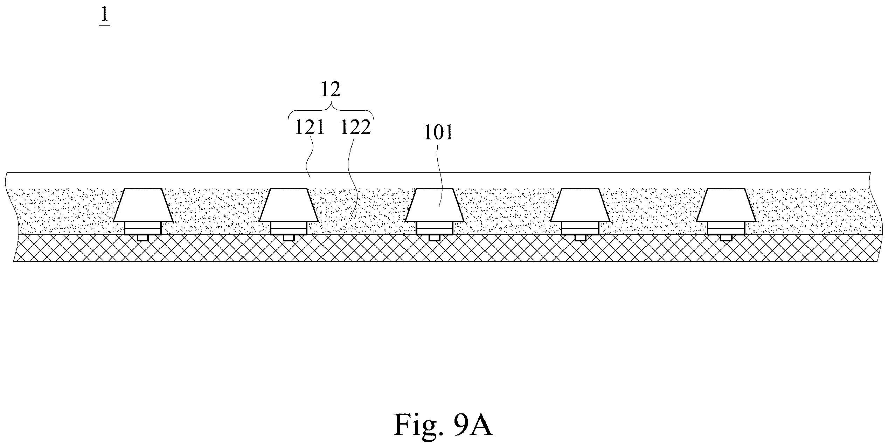

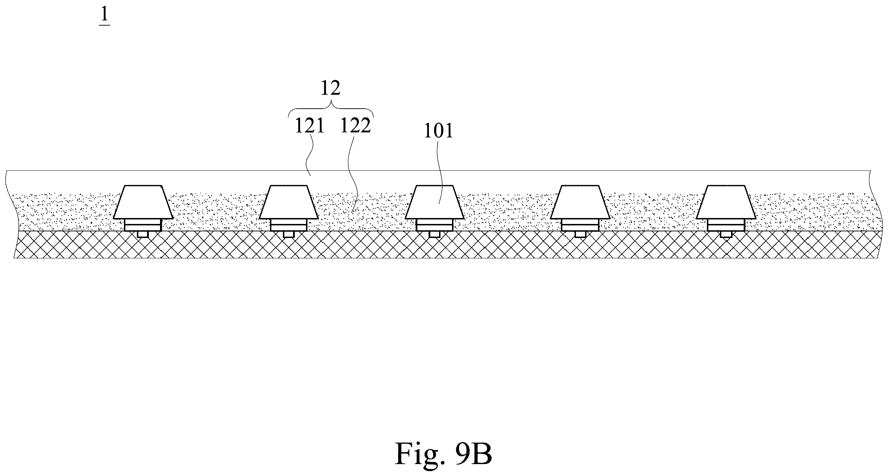

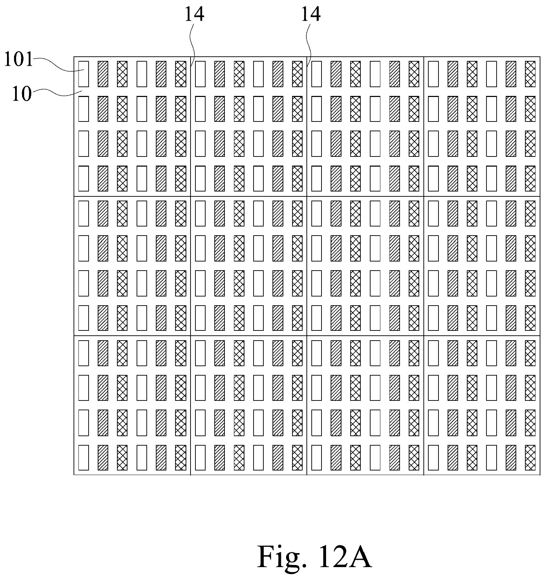

With reference to FIGS. 6, 7B and 7A for a flow chart of a micro LED light emitting device manufacturing method, a schematic view and a top view of a micro LED light emitting device in accordance with a preferred embodiment of this disclosure respectively, this disclosure discloses a manufacturing method of a micro LED light emitting device 1 having a barrier layer 12 and performing a manufacturing process in a vacuum cavity 2. The manufacturing method comprises the following steps:
Step S01: Provide at least one light emitting element 10, wherein the light emitting element 10 has a plurality of micro LEDs 101 arranged into a matrix of 2*2 or more. For example, a light emitting element 10 serving as a light source of a display device can further choose the micro LEDs 101 of 2*2 RGGB as a unit, and the is then expanded, or a RGB is used as a unit and arranged into two rows. The light emitting element 10 is installed onto a base 20 inside the cavity 2, and the adjacent micro LEDs 101 have a gap 103 therebetween to form a trellis ditch 105. Further, when the plurality of light emitting elements 10 are spliced, the range of the trellis ditch 105 includes adjacent areas of the light emitting elements 10. In other words, a gap is formed between the micro LEDs 101 of each light emitting element 10 and the micro LED 101 of the adjacent light emitting element 10 as shown in FIG. 12A.
Step S02: Set a barrier layer 12 onto the micro LEDs 101, wherein the barrier layer 12 comprises an upper portion 121 and a lower portion 122, wherein the upper portion 121 has a light transmittance greater than or equal to 85%, and the lower portion 122 has a light transmittance smaller than or equal to 30%. Preferably, the lower portion 122 has an optical property of light absorption or light reflection. For example, a black light-absorbent material is used as a material for absorbing light, and a silver or bright surfactant is used as a material for reflecting light. Even the material of the light absorption or light reflection cannot absorb or reflect the light completely, and such material can achieve a certain degree of light absorption or light reflection only, and this material is considered as a material with very good light blocking effect in this disclosure. Since the barrier layer 12 is formed by attaching two or more homogeneous or heterogeneous composites, and their adhesiveness and flow stagnation vary, therefore when the laminated barrier layer 12 flows and moves in the trellis ditch 105, the composites may be separated from each other easily due to the poor adhesion. In an embodiment of this disclosure, the barrier layer 12 is formed by using an opaque material doping into a transparent material and allowed precipitating to form the lower portion 122 and the upper portion 121 with different light transmittances. With this integral two-color structure, the barrier layer 12 after being laminated has a better flowing effect, and the problem of having a separation between the composites will not occur in same structure after being laminated.
Step S03: Apply a pressure directly or indirectly to the barrier layer 12 by a hot-pressed part 21 to produce deformation, so that the lower portion 122 of the barrier layer 12 flows into the trellis ditch 105, and the lower portion 122 after being filled into the trellis ditch 105 has a height L relative to the height H of the micro LEDs 101, and 0.7H≦ L≦1.2H, and the upper portion 121 is covered onto the lower portion 122, so that there is no gap between the barrier layer 12 and the micro LEDs 101. With reference to FIGS. 9A and 9B for the performance of the barrier layer 12 filled into the trellis ditch 105, the lower portion 122 in the trellis ditch 105 of these two embodiments has a height equal to or slightly smaller than the height of the micro LEDs 101. Regardless of which embodiment, the effect of blocking the mutual interference of the lights can be achieved effectively without affecting the light performance. Furthermore, a side of the micro LED 101 is not perpendicularly coupled to the connected circuit substrate in a perfect manner, so that the lamination technology used in this disclosure can fill the barrier layer 12 into the trellis ditch 105 effectively, and there is no gap between the barrier layer 12 and the micro LEDs 101 after the barrier layer 12 is filled into the trellis ditch 105.

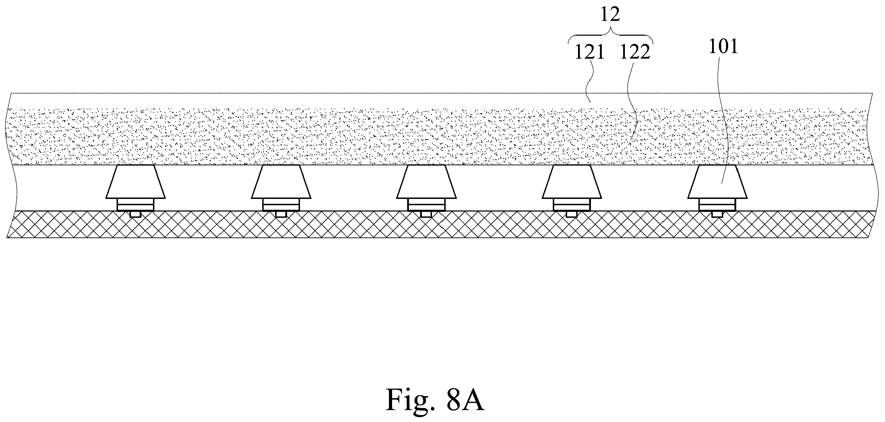

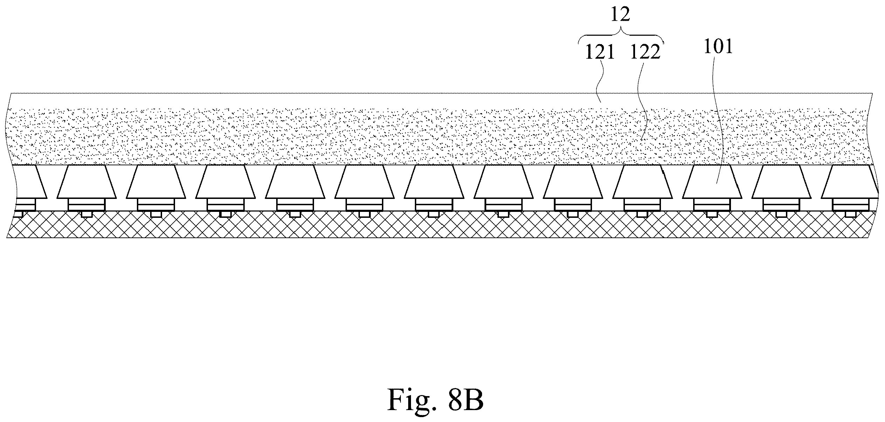

Further, the quantity of the lower portions 122 is determined by different heights of the corresponding micro LEDs 101 and the gap 103 between the micro LEDs 101. As to the quantity of the upper portions 121, the quantity should be slightly greater than the quantity required for covering the micro LEDs 101. With reference to FIGS. 8A and 8B for the schematic views of the barrier layers that fit the trellis ditches of different sizes in accordance with an embodiment of this disclosure respectively, it is just necessary to measure the height of the micro LEDs 101 and the gap 103 between the micro LEDs 101 to determine the quantity of lower portions 122 of the barrier layer 12 to fit different-sized trellis ditches 105, and the manufacturing method of this disclosure can be used to set the barrier layer 12 at a time quickly and completely.

In an embodiment, the aforementioned method is used for manufacturing a micro LED light emitting device 1, and the micro LED light emitting device 1 comprises: at least one light emitting element 10, wherein the light emitting element 10 has a plurality of micro LEDs 101 arranged into a matrix of 2*2 or more, wherein the adjacent micro LEDs 101 have a gap 103 therebetween to form a trellis ditch 105, and the micro LEDs 101 has a height H; and a barrier layer 12 has an upper portion 121 and a lower portion 122, wherein the upper portion 121 has a light transmittance greater than or equal to 85%, and the lower portion 122 has a light transmittance smaller than or equal to 30%; and the lower portion 122 after being filled into the trellis ditch 105 has a height L, and 0.7H≦L≦1.2H, and the upper portion 121 is covered onto the lower portion 122, and there is no gap between the barrier layer 12 and the micro LEDs 101. Similarly to the aforementioned manufacturing method, the opaque material of the barrier layer 12 has an optical property of light absorption or light reflection, and the barrier layer 12 is formed by using an opaque material doping into a transparent material and allowed precipitating to form the lower portion and the upper portion 121 with different light transmittances 122. In the meantime, the transparent material is PMMA; and the micro LEDs 101 have a height smaller than or equal to 130µm. Under the condition of such small size, this disclosure still can set the barrier layer 12 between the micro LEDs 101 effectively without blocking the light.

Preferably, when the light emitting element 10 comes with a single or plural quantity, a buffer layer 22 is further disposed between the hot-pressed part 21 and the barrier layer 12 in the manufacturing method, and the hot-pressed part 21 applies a pressure indirectly to the barrier layer 12 by the buffer layer 22, or the barrier layer 12 is attached and fixed to a carrier plate 13, and the carrier plate 13 receives the pressure applied by the hot-pressed part 21 first, and then the barrier layer 12 is deformed indirectly, so as to improve the flowing effect of the laminated barrier layer 12 and prevent the laminated barrier layer 12 from being damaged easily. For example, silicone is used for making the buffer layer 22, so that the pressure can be applied evenly to the barrier layer 12 when pressed. The carrier plate 13 is made of a transparent PET material, and the portion of the transparent barrier layer 12 is covered to protect the micro LEDs 101 indirectly. In the manufacturing process of the vacuum cavity 2, the process condition can be set to at least 200Pa; and the process temperature inside the cavity 2 is greater than or equal to 60 degrees Centigrade, and the process is carried out for at least 1 min. 20 seconds, and the press strength of the hot-pressed part 21 is greater than or equal to 500 newtons, so as to obtain a better hot-press flowing effect.

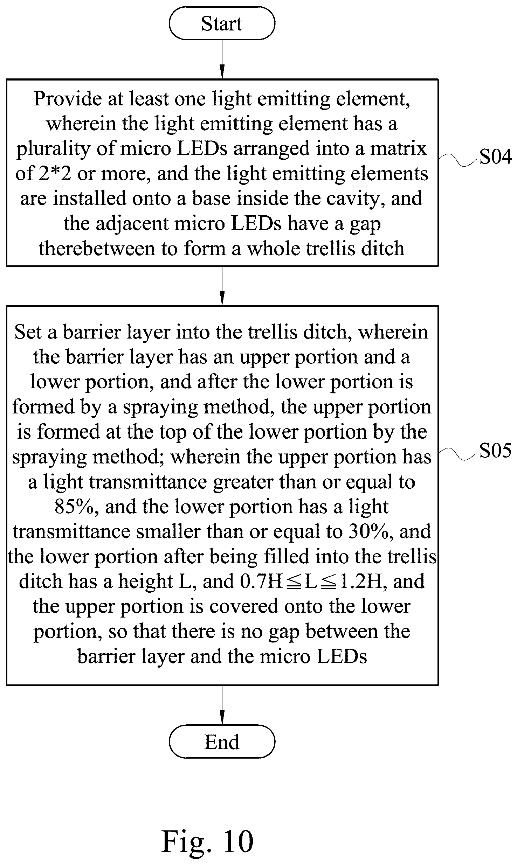

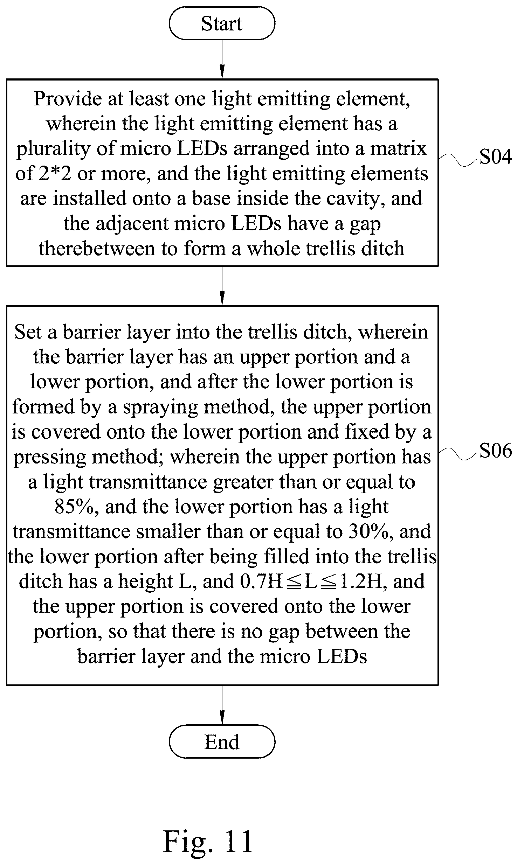

In order to set the barrier layer 12 between the micro LEDs 101 effectively, this disclosure further discloses two other micro LED light emitting device manufacturing methods as shown in FIGS. 10 and 11.

Step S04: Provide at least one light emitting element 10, wherein the light emitting element 10 has a plurality of micro LEDs 101 arranged in a matrix of 2*2 or more, and the adjacent micro LEDs 101 have a gap 103 therebetween to form a trellis ditch 105. The steps S05 and S06 adopt different barrier layers 12 to achieve the aforementioned structural characteristics of this disclosure.

Step S05: Set a barrier layer 12 into the trellis ditch 105, wherein the barrier layer 12 has an upper portion 121 and a lower portion 122, and form the upper portion 121 at the top of the lower portion 122 by a spraying method after the lower portion 122 is formed by the spraying method, wherein the upper portion 121 has a light transmittance greater than or equal to 85%, and the lower portion 122 has a light transmittance smaller than or equal to 30%, and the lower portion 122 after being filled into the trellis ditch 105 has a height L, and 0.7H≦L≦1.2H, and the upper portion 121 is covered onto the lower portion 122, so that there is no gap between the barrier layer 12 and the micro LEDs 101.

Step S06: Step S06 is carried out immediately after the step S04, a barrier layer 12 is formed into the trellis ditch 105, wherein the barrier layer 12 has an upper portion 121 and a lower portion 122, and the upper portion 121 is covered onto the lower portion 122 and then fixed by a pressing method after the lower portion 122 is formed by the spraying method, wherein the upper portion 121 has a light transmittance greater than or equal to 85%, and the lower portion 122 has a light transmittance smaller than or equal to 30%, and the lower portion 121 after being filled into the trellis ditch 105 has a height L, and 0.7H≦L≦1.2H, and the upper portion 121 is covered onto the lower portion 122, so that there is no gap between the barrier layer 12 and the micro LEDs 101. Since the spraying technology can attach the barrier layer 12 into the trellis ditch 105 effectively, therefore the continuity of the material after the lower portion 122 and the upper portion 121 can enhance the overall stability of the packaged micro LED lighting devices effectively.

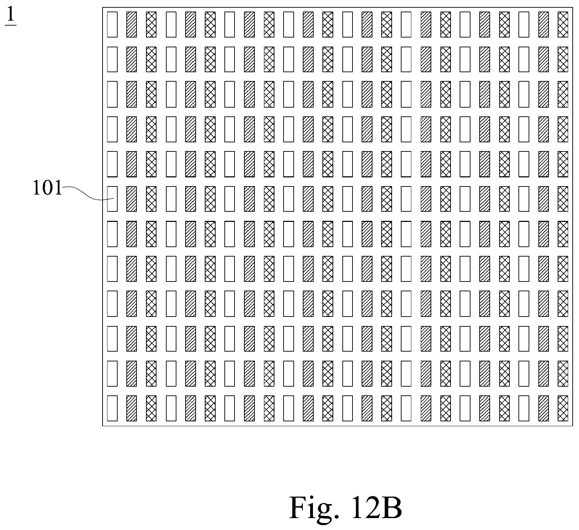

In the aforementioned manufacturing methods, a single light emitting element 10 or a plurality of spliced light emitting elements 10 can be manufactured. When the light emitting element 10 comes with a plural quantity, the trellis ditch 105 comprises adjacent areas with the light emitting elements 10 arranged next to each other. With reference to FIGS. 12A and 12B for the schematic views of a plurality of light emitting elements spliced with each other and having and not having a barrier layer in accordance with this disclosure respectively, the position of a splicing line 14 as shown in FIG. 12A is situated in the adjacent area where the light emitting elements 10 are arranged next to each other, and the manufacturing method of this disclosure can cover the splicing line 14 to improve the aesthetic appearance of the display device. Regardless of the size of the display device, this method can be applied effectively.

In summation of the description above, the micro LED light emitting device and its manufacturing method of this disclosure have no gap between the barrier layer and the micro LEDs, so as to achieve an excellent overall stability. In addition, the barrier layer with the structures of two different light transmittances can block the mutual interference of the lights of adjacent micro LEDs or pixels. In general, the barrier layer of this disclosure uses a two-layer structure with different light transmittances, and has no gap between the barrier layer and the micro LEDs to enhance the stability of the overall packaged micro LED light emitting device without affecting its light performance. In the meantime, the lower portion has a specific height relative to the micro LEDs to satisfy the condition of 0.7H≦L≦1.2H and achieve the effects of blocking the mutual interference of adjacent side lights as much as possible and enhancing the overall lighting effect. Unlike the conventional dispensers having the drawbacks of taking much time and having difficulty to form the barrier layer between the micro LEDs, the manufacturing method of this disclosure has a high efficiency. For the micro LEDs with a very small size, the method of this disclosure can set the barrier layer between the micro LEDs accurately. When it is necessary to expand the display range by splicing a plurality of light emitting elements, this technical measure of this disclosure can be used to cover the splicing line included in the adjacent areas and improve the aesthetic appearance of the display device.

## Claims

1. A micro LED light emitting device, comprising:
at least one light emitting element, having a plurality of micro LEDs installed thereon and arranged into a matrix of 2*2 or more, wherein adjacent micro LEDs have a gap therebetween to form a trellis ditch, and the plurality of micro LEDs have a height H; and
a barrier layer, having an upper portion and a lower portion, wherein the upper portion has a light transmittance greater than or equal to 85%, the lower portion has a light transmittance smaller than or equal to 30%; the lower portion is filled into the trellis ditch and has a height L, and 0.7H≦L≦1.2H, and the upper portion is covered onto the lower portion, and no gap exists between the barrier layer and the plurality of micro LEDs.

2. The LED light emitting device as claimed in claim 1, wherein the barrier layer is a deformable material, the barrier layer is formed by using an opaque material doping into a transparent material and allowed precipitating to form the lower portion and the upper portion with different light transmittances.

3. The LED light emitting device as claimed in claim 2, wherein the opaque material has an optical property of light absorption or light reflection.

4. The LED light emitting device as claimed in claim 3, wherein the transparent material is PMMA.

5. The LED light emitting device as claimed in claim 4, wherein the plurality of micro LEDs have a height smaller than or equal to 130µm.

6. The LED light emitting device as claimed in claim 1, wherein the lower portion and the upper portion of the barrier layer are formed sequentially by a spraying method.

7. The LED light emitting device as claimed in claim 1, wherein the lower portion of the barrier layer is formed by a spraying method, and then the upper portion is covered onto the lower portion and fixed by a pressing method.

8. The LED light emitting device as claimed in claim 1, wherein when the light emitting element comes with a plural quantity, the trellis ditch comprises adjacent areas with the light emitting elements arranged next to each other.

9. The LED light emitting device as claimed in claim 8, wherein the barrier layer is a deformable material, the barrier layer is formed by using an opaque material doping into a transparent material and allowed precipitating to form the lower portion and the upper portion with different light transmittances.

10. The LED light emitting device as claimed in claim 9, wherein the opaque material has an optical property of light absorption or light reflection.

11. The LED light emitting device as claimed in claim 10, wherein the transparent material is PMMA.

12. The LED light emitting device as claimed in claim 11, wherein the micro LEDs have a height smaller than or equal to 130µm .

13. The LED light emitting device as claimed in claim 8, wherein the lower portion and the upper portion of the barrier layer are formed sequentially by using a spraying method.

14. The LED light emitting device as claimed in claim 8, wherein the lower portion of the barrier layer is formed by using a spraying method, and then the upper portion is covered onto the lower portion, and fixed by a pressing method.

15. A micro LED light emitting device manufacturing method, used for performing a manufacturing process in a vacuum cavity, comprising the steps of:
providing at least one light emitting element, wherein the light emitting element has a plurality of micro LEDs arranged into a matrix of 2*2 or more, and the light emitting elements are installed onto a base inside the vacuum cavity, and the adjacent micro LEDs have a gap therebetween to form a trellis ditch;
setting a barrier layer onto the plurality of micro LEDs, wherein the barrier layer has an upper portion and a lower portion, and the upper portion has a light transmittance greater than or equal to 85%, and the lower portion has a light transmittance smaller than or equal to 30%; and
applying a pressure directly or indirectly to the barrier layer by a hot-pressed part to produce deformation, so as to move and flow the lower portion of the barrier layer into the trellis ditch, and the lower portion after being filled into the trellis ditch has a height L, and 0.7H≦L≦1.2H, and the upper portion is covered onto the lower portion, so that there is no gap between the barrier layer and the plurality of micro LEDs.

16. The manufacturing method as claimed in claim 15, wherein the barrier layer is formed by using an opaque material doping into a transparent material and allowed precipitating to form the lower portion and the upper portion with different light transmittances.

17. The manufacturing method as claimed in claim 16, wherein the opaque material has an optical property of light absorption or light reflection.

18. The manufacturing method as claimed in claim 17, wherein the hot-pressed part and the barrier layer has a buffer layer disposed therebetween, and the hot-pressed part applies a pressure to the barrier layer indirectly through the buffer layer.

19. The manufacturing method as claimed in claim 18, wherein the barrier layer is attached and fixed to a carrier plate, and when the hot-pressed part applies the pressure, the carrier plate receives the pressure first, and then the barrier layer produces deformation indirectly.

20. The manufacturing method as claimed in claim 19, wherein a process temperature in the vacuum cavity is greater than or equal to 60 degrees Centigrade.

21. The manufacturing method as claimed in claim 20, wherein the hot-pressed part has a press strength greater than or equal to 500 newtons.

22. The manufacturing method as claimed in claim 15, wherein when the light emitting element comes with a plural quantity, the trellis ditch comprises adjacent areas with the light emitting elements arranged next to each other.

23. The manufacturing method as claimed in claim 22, wherein the barrier layer is formed by using an opaque material doping into a transparent material and allowed precipitating to form the lower portion and the upper portion with different light transmittances.

24. The manufacturing method as claimed in claim 23, wherein the opaque material has an optical property of light absorption or light reflection.

25. The manufacturing method as claimed in claim 24, wherein the hot-pressed part and the barrier layer has a buffer layer disposed therebetween, and the hot-pressed part applies a pressure to the barrier layer indirectly through the buffer layer.

26. The manufacturing method as claimed in claim 25, wherein the barrier layer is attached and fixed to a carrier plate, and the hot-pressed part applies the pressure, the carrier plate receives the pressure first, and then the barrier layer produces deformation indirectly.

27. The manufacturing method as claimed in claim 26, wherein the process temperature inside the vacuum cavity is greater than or equal to 60 degrees Centigrade.

28. The manufacturing method as claimed in claim 27, wherein the hot-pressed part has a press strength greater than or equal to 500 newtons.

29. A manufacturing method of a micro LED light emitting device, comprising:
providing at least one light emitting element, wherein the light emitting element has a plurality of micro LEDs arranged into a matrix of 2*2 or more, and the adjacent micro LEDs have a gap therebetween to form a trellis ditch; and
setting a barrier layer into the trellis ditch, wherein the barrier layer has an upper portion and a lower portion, and after the lower portion is formed by a spraying method, the upper portion is formed at top of the lower portion by the spraying method; wherein the upper portion has a light transmittance greater than or equal to 85%, and the lower portion has a light transmittance smaller than or equal to 30%, and the lower portion after being filled into the trellis ditch has a height L, and 0.7H≦L≦1.2H, and the upper portion is covered onto the lower portion, so that there is no gap between the barrier layer and the micro LEDs.

30. The manufacturing method as claimed in claim 29, wherein when the light emitting element comes with a plural quantity, the trellis ditch comprises adjacent areas with the light emitting elements arranged next to each other.

31. A manufacturing method of a micro LED light emitting device, comprising the steps of:
providing at least one light emitting element, wherein the light emitting element has a plurality of micro LEDs arranged into a matrix of 2*2 or more, and the adjacent micro LEDs have a gap therebetween to form a trellis ditch; and
setting a barrier layer into the trellis ditch, wherein the barrier layer has an upper portion and a lower portion, and after the lower portion is formed by a spraying method, the upper portion is covered onto the lower portion and fixed by a pressing method; wherein the upper portion has a light transmittance greater than or equal to 85%, and the lower portion has a light transmittance smaller than or equal to 30%, and the lower portion after being filled into the trellis ditch has a height L, and 0.7H≦L≦1.2H, and the upper portion is covered onto the lower portion, so that there is no gap between the barrier layer and the micro LEDs.

32. The manufacturing method as claimed in claim 31, wherein when the light emitting element comes with a plural quantity, the trellis ditch comprises adjacent areas with the light emitting elements arranged next to each other.
